# EUROPÄISCHE PATENTSCHRIFT

(11) **EP 1 366 568 B1**
(45) Veröffentlichungstag und Bekanntmachung des Hinweises auf die Patenterteilung: **06.10.2004**
(21) Anmeldenummer: 02706716.4
(22) Anmeldetag: 18.01.2002
(51) Int. Cl.: H03K 17/082

(54) **SCHALTUNGSANORDNUNG ZUM ÜBERSTROM-FREIEN EIN- UND AUSSCHALTEN EINES STROMES**
CIRCUIT ARRANGEMENT FOR SWITCHING A CURRENT ON AND OFF WITHOUT THE OCCURRENCE OF OVERCURRENT
CIRCUIT D'ENCLENCHEMENT ET DE COUPURE, SANS SURINTENSITE, D'UN COURANT

(30) Priorität: 08.03.2001 DE 20104111 U
(43) Veröffentlichungstag der Anmeldung: 03.12.2003
(73) Patentinhaber: IC-HAUS GmbH, D-55294 Bodenheim (DE)
(72) Erfinder: HERZ, Manfred, 55130 Mainz (DE); PINEDA GARCIA, Alvaro, 56154 Boppard (DE)
(74) Vertreter: Kampfenkel, Klaus, Dipl.-Ing.
(86) Internationale Anmeldenummer: PCT/EP2002/000453
(87) Internationale Veröffentlichungsnummer: WO 2002/082650

(56) Entgegenhaltungen:
- EP-A- 0 703 664
- EP-A- 0 810 732
- US-A- 5 539 336
- US-A- 5 608 339
- PATENT ABSTRACTS OF JAPAN vol. 008, no. 277 (E-285), 18. Dezember 1984 (1984-12-18) & JP 59 147476 A (HITACHI KOKI KK), 23. August 1984 (1984-08-23)

## Beschreibung

Die Erfindung betrifft eine Schaltungsanordnung zum Überstrom-freien Ein- und Ausschalten eines Stromes, der beispielsweise zum Ansteuern einer Laserdiode verwendet wird.

Schaltungsanordnungen zum Ein- und Ausschalten eines eine Last treibenden Stromes sind bekannt, z.B. aus US 5 608 339.

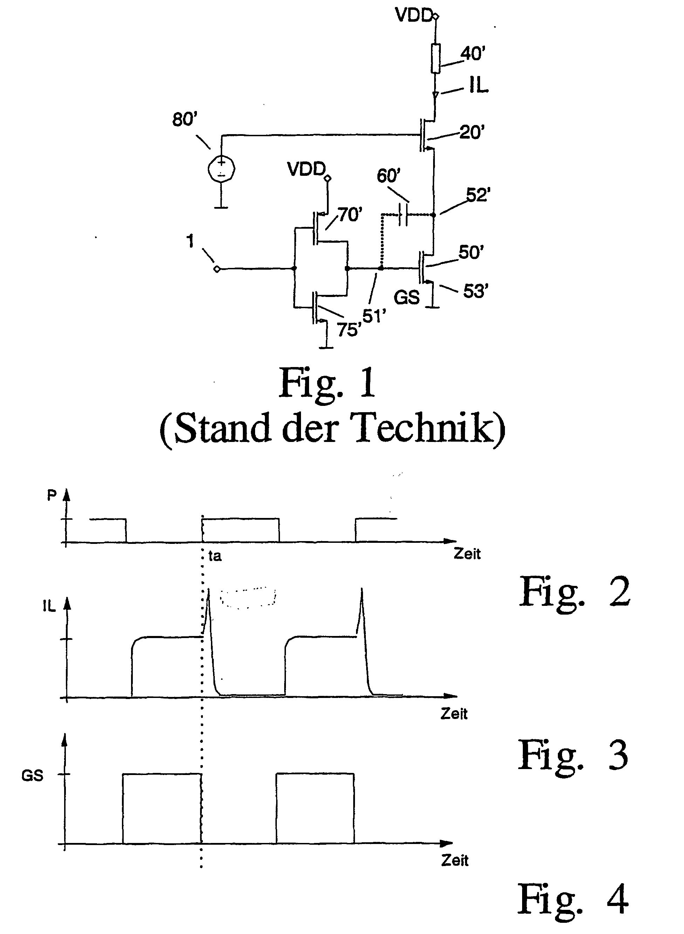

Fig. 1 zeigt eine solche Schaltungsanordnung, die einen Transistor 20' als Stromquelle oder Stromsenke benutzt. Die Steuerelektrode des Transistors 20' ist mit einer Gleichspannungsquelle 80' verbunden. Die Stromquelle 20' ist in Reihe mit einer Last 40', beispielsweise mit einer Laserdiode, verbunden. Als Schalter für die Stromquelle dient ein Schalttransistor 50', der ebenfalls in Reihe mit der Stromquelle 20' geschaltet ist. Der beispielsweise als Feldeffekttransistor ausgebildete Schalttransistor 50' ist über seine Gate-Elektrode 51' mit einer Ansteuereinrichtung verbunden, welche beispielsweise aus den Transistoren 75' und 70' besteht. An den Eingang 1 der Ansteuereinrichtung 70', 75' wird ein Ein-/Ausschaltsignal P angelegt, wie beispielsweise in Fig. 2 dargestellt ist. Zwischen dem Gate 51' und der Drain-Elektrode 52' des Schalttransistors 50' liegt eine herstellungsbedingte parasitäre Kapazität 60', die auch als Miller-Kapazität bekannt ist. Wie später noch erläutert wird, ist diese parasitäre Kapazität Ursache für Überströme, die beim Ausschalten der Stromquelle 20' hervorgerufen werden. Durch die Gate-Source-Spannung GS des Schalttransistors 50' wird der Zustand des Schalttransistors gesteuert. Falls diese Gate-Source-Spannung GS kleiner als die Schwellenspannung des Schalttransistors 50' ist, wird der Strom IL durch den Schalttransistor 50' unterbrochen. Die Steuerung der Gate-Source-Spannung GS erfolgt über die Ansteuereinrichtung 70', 75'. Allerdings tritt beim Abschalten des Schalttransistors 50' und damit der Stromquelle 20' ein Überstrom, auch Stromspike genannt, auf, der von der parasitären Kapazität 60' des Schalttransistors 50' herrührt. Denn bei abfallender Flanke der Gate-Source-Spannung GS am Schalttransistors 50', deren Verlauf in Fig. 4 dargestellt ist, überträgt die parasitäre Kapazität 60' den Spannungssprung an der Steuerelektrode 51' zur Ausgangselektrode 52' des Schalttransistors 50' und steuert den Transistor 20' stärker an. Dadurch wird ein Überstrom durch die Last 40' verursacht, wie dies in Fig. 3 zum Zeitpunkt tₐ dargestellt ist. Der Überstrom fließt, bis die parasitäre Kapazität umgeladen ist. Der Zeitpunkt tₐ kennzeichnet den Zeitpunkt, zu dem das Ausschaltsignal an den Eingang 1 der Ansteuereinrichtung 70', 75' angelegt wird. Derartige Stromspitzen können bei bestimmten Anwendungen zur Zerstörung der Last 40' führen, wie dies z.B. bei einer Laserdiode der Fall sein kann.

Der Erfindung liegt nunmehr die Aufgabe zugrunde, die eingangs beschriebene Schaltungsanordnung zum Ein- und Ausschalten eines Stroms derart zu verbessern, dass Überströme beim Ausschalten einer Stromquelle vermieden werden können.

Dieses technische Problem löst die Erfindung mit den Merkmalen des Anspruchs 1.

Danach wird eine Schaltungsanordnung zum Überstrom-freien Ein- und Ausschalten eines Stromes bereitgestellt. Die Schaltungsanordnung weist eine Stromquelle, eine der Stromquelle zugeordnete Last sowie einen Schalttransistor zum Ein- und Ausschalten der Stromquelle auf. Herstellungsbedingt enthält der Schalttransistor eine parasitäre Kapazität zwischen der Steuerelektrode und einer ersten Ausgangselektrode, die Umladeströme beim Ausschalten der Stromquelle verursacht. Mit einer zwischen der Steuerelektrode und der ersten Ausgangselektrode der Schalteinrichtung geschalteten Kurzschlusseinrichtung zum Ausschalten der Stromquelle kann verhindert werden, dass die Umladeströme zu Überströmen in der Last führen.

Zweckmäßigerweise ist die Kurschlusseinrichtung als Transistor implementiert, an dessen Steuerelektrode ein Ein/Ausschaltesignal anlegbar ist. Eine Ausgangselektrode der Kurzschlusseinrichtung ist mit der ersten Ausgangselektrode des Schalttransistors und die andere Ausgangselektrode der Kurzschlusseinrichtung ist mit der Steuerelektrode des Schalttransistors verbunden. Die Kurzschlusseinrichtung schließt auf diese Weise den Schalttransistor kurz und damit die Stromquelle aus.

Um die Ein- und Ausgangszyklen verkürzen zu können, ist parallel zur Kurzschlusseinrichtung eine Pull-up-Einrichtung geschaltet, die dafür sorgt, dass im Einschaltzeitpunkt das Potential an der Steuerelektrode des Schalttransistors angehoben werden kann.

Stromquelle, Schalttransistor, Kurzschlusseinrichtung und/oder auch die Pull-up-Einrichtung können als BipolarTransistoren, als Feldeffekttransistoren, insbesondere MOS-Transistoren, oder als Kombinationen aus diesen Technologien ausgebildet sein.

Die Schaltungsanordnung ist vor allem zum Treiben einer Laserdiode als Last geeignet.

Die Erfindung wird nachstehend anhand eines Ausführungsbeispiels in Verbindung mit den beiliegenden Zeichnungen näher erläutert.
Es zeigen:
- Fig. 1: eine Schaltungsanordnung zum Ein-/Ausschalten eines Stromes gemäß dem Stand der Technik,
- Fig. 2: den zeitlichen Verlauf eines Ein-Ausschaltsignals,
- Fig. 3: den Laststrom IL durch die Last 40',
- Fig. 4: den Potentialverlauf an der Steuerelektrode des Schalttransistors nach Fig. 1,
- Fig. 5: eine Schaltungsanordnung gemäß der Erfindung,
- Fig. 6: den zeitlichen Verlauf eines Ein-/Ausschaltsignals entsprechend der Fig. 2,
- Fig. 7: den Potentialverlauf an der Steuerelektrode des in Fig. 5 gezeigten Schalttransistors,
- Fig. 8: den Stromverlauf durch die in Fig. 5 gezeigte parasitäre Kapazität, und
- Fig. 9: den zeitlichen Verlauf eines Überstrom freien Laststroms.

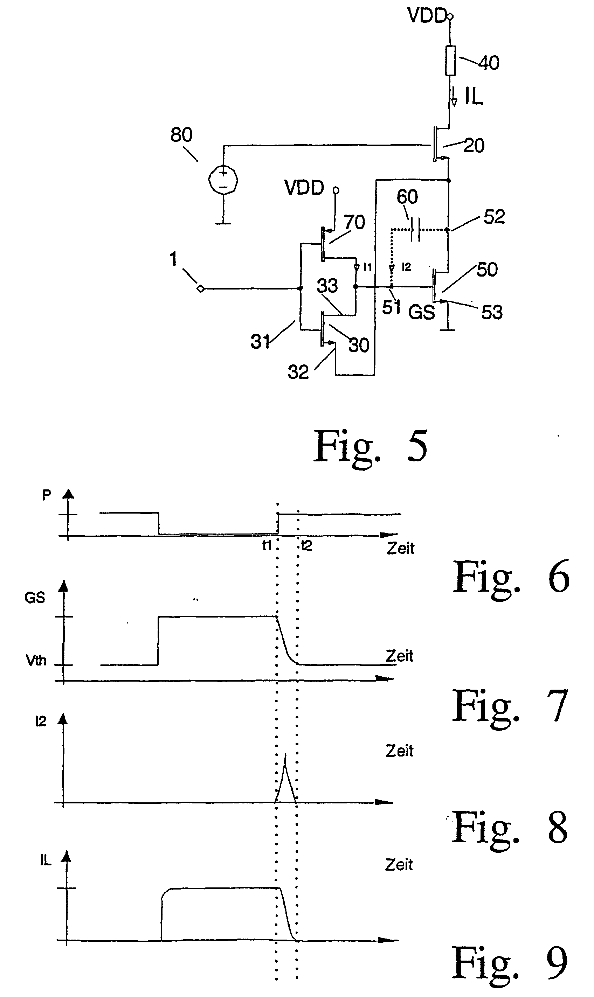

Fig. 5 zeigt eine Schaltungsanordnung 10, die Komponenten der Schaltungsanordnung nach Fig. 1 enthält. Eine Last, beispielsweise eine Laserdiode 40, ist mit der Drain-Elektrode eines als Stromquelle betriebenen beispielhaften n-Knanal-Feldeffekttransistors 20 verbunden. An dem Gate der Stromquelle 20 liegt eine konstante Spannung an, die von der Gleichspannungsquelle 80 geliefert wird. Die Source-Elektrode der Stromquelle 20 ist mit der Drain-Elektrode 52 eines als Schalttransistors 50 fungierenden beispielhaften n-Kanal-Feldeffekttransistors verbunden, so dass die Last 40, die Stromquelle 20 und der Schalttransistor 50 eine Reihenschaltung bilden. Die Source-Elektrode 53 des Schalttransistors 50 ist mit Masse verbunden. Ferner ist ein Kurzschluss-Transistor 30, der beispielsweise als n-Kanal-Feldeffekttransistor implementiert ist, vorgesehen, dessen Drain-Elektrode 33 mit dem Gate 51 des Schalttransistors 50 verbunden ist, wohingegen die Source-Elektrode 32 des Kürzschluss-Transistors 30 mit der Drain-Elektrode 52 des Schalttransistors unmittelbar verbunden ist.

Es ist wichtig darauf hinzuweisen, dass der Kurzschluss-Transistor 30 im Unterschied zur in Fig. 1 gezeigten Schaltungsanordnung das Gate 51 des Schalttransistors 50 im leitenden Zustand nicht mit Masse sondern mit der Drain-Elektrode 52 des Schalttransistors 50 verbindet. Auf diese Weise kann, wie später noch ausführlich erläutert wird, die herstellungsbedingte parasitäre Kapazität 60 zwischen dem Gate 51 und der Drain-Elektrode 52 des Schalttransistors 50 im Ausschaltzeitpunkt des Schalttransistors 50 kurzgeschlossen werden, wodurch gleichzeitig der Schalttransistor 50 zu einem Zweipol geschaltet wird, über den die Schellenspannung abfällt.

Das Gate 31 des Kurzschluss-Transistors 30 ist mit einem Eingangsanschluss 1 verbunden, an den das in Fig. 6 dargestellte Ein-/Ausschaltsignal P angelegt werden kann. Parallel zum Kurzschluss-Transistor 30 kann ein Pull-up-Element 70, beispielsweise ein als p-Kanal-Feldeffekttransistor implementierter Pull-up-Transistor, geschaltet sein, dessen Gate ebenfalls mit dem Eingang 1 der Schaltungsanordnung verbunden ist. Der Pull-up-Transistor 70 ist im Unterschied zum Kurzschluss-Transistor 30 als P-Kanal-Feldeffekttransistor ausgebildet. Die Source-Elektrode des Pull-up-Transistors 70 ist mit der Betriebsspannung VDD verbunden, wohingegen die Drain-Elektrode mit dem Gate 51 des Schalttransistors 50 verbunden ist. Auf diese Weise kann im Einschaltzeitpunkt das Gate 51 des Schalttransistors 50 schneller auf ein Potential gezogen werden, welches über der Schwellenspannung des Schalttransistors 50 liegt, so dass der Schalttransistor schneller durchschalten und damit die Stromquelle 20 einschalten kann.

Nunmehr wird die Funktionsweise der Schaltungsanordnung 10 beim Ausschalten des Stromes in Verbindung mit den Figuren 6 bis 9 im einzelnen erläutert.

Zunächst wird die Phase betrachtet, während der der Schalttransistor 50 und damit die Stromquelle 20 eingeschaltet sind. Während dieser Zeit liegt das Einschaltsignal P gemäß Fig. 6 am Eingang 1 an, welches im erläuterten Beispiel während dieser Zeit einen Low-Pegel annimmt. Infolge des Low-Pegels sperrt der Kurzschluss-Transistor 30 und das Potential am Gate 51 des Schalttransistors 50 wird über den Pull-up-Transistor 70, der während dieser Zeitspanne leitend ist, auf Betriebsspannung gehalten, wie in Fig 7 gezeigt. Da die Betriebsspannung höher als die Schwellenspannung des Schalttransistors 50 gewählt ist, fließt folglich ein Strom durch den Schalttransistor 50 und der Laststrom IL durch die Last 40 und die Stromquelle 20, wie in Fig. 9 dargestellt. Mit anderen Worten ist die Stromquelle 20 eingeschaltet.

Angenommen sei nunmehr, dass am Eingang 1 der Schaltungsanordnung zum Zeitpunkt t₁ ein Ausschaltsignal P angelegt wird, so dass das Potential am Eingang 1 von Low auf High geht. Dieser Zeitpunkt t₁ ist in Fig. 6 dargestellt.

Zu diesem Zeitpunkt beginnt der Kurzschluss-Transistor 30 zu leiten und verbindet das Gate 51 des Schalttransistors 50 mit der Drain-Elektrode 52. Demzufolge fließt der Umladestrom I2 der parasitären Kapazität 60 über den Kurzschluss-Transistor 30, wie in Fig. 8 gezeigt. Dieser Umladestrom fließt somit nicht mehr als Stromspitze durch die Last 40. Der Strom I1, der über den Pull-up-Transistor 70 fließt, fließt im Wesentlichen durch den Kurzschlusstransistor 30 und weiter über den Schalttransistor 50 zur Masse ab. Diese Phase dauert bis zum Zeitpunkt t₂, zu dem die Spannung am Gate 51 des Schalttransistors 50 dessen Schwellenspannung Vth erreicht hat. Diese Phase ist in Fig. 7 durch die abfallende Flanke des Gate-Sourcespannung zwischen den Zeitpunkten t₁ und t₂ dargestellt. Sobald die Spannung an der Drainelektrode 52 des Schalttransistors 50 so groß geworden ist, dass die Schwellenspannung Vth der Stromquelle 20 unterschritten wird, wird die Stromquelle 20 ausgeschaltet. Da der Kurzschluss-Transistor 30 das Gate 51 und die Drain-Elektrode 52 kurzschließt, liegt an beiden Punkten das gleiche Potential an. Demzufolge kann, wie erwähnt, der Umladestrom der parasitären Kapazität 60 über den Kurzschluss-Transistor 30 fließen. Der in Fig. 9 gezeigte Überstrom freie Laststrom IL fällt somit zwischen den Zeitpunkten t₁ und t₂ auf nahezu Null ab. Die Bedingung dafür, dass der Laststrom IL durch den Schalttransistors 50 abgeschaltet wird, ist, dass die am Gate der Stromquelle 20 anliegende konstante Spannung kleiner als die Summe der Schwellenspannungen der Stromquelle 20 und des Schalttransistors 50 ist.

Um die Ein- und Ausgangsschaltvorgänge weiter beschleunigen oder den Arbeitsbereich erweitern zu können, können die Potentiale am Gate der Stromquelle oder am Gate des Schalttransistors 50 durch weitere stets angeschaltete oder dynamisch anschaltbare Stromsenken beim Ausschalten abgesenkt oder beim Einschalten angehoben werden.

### Bezugszeichenliste

- 1: Eingang
- 10: Schaltungsanordnung
- 20, 20': Stromquelle
- 30: Kurzschlusseinrichtung
- 31: Gate
- 32: Sourceelektrode
- 33: Drainelektrode
- 40, 40': Last, Laserdiode
- 50, 50': Schalttransistor
- 51, 51': Steuerelektrode, Gate
- 52, 52': Drainelektrode
- 53, 53': Sourceelektrode
- 60, 60': parasitäre Kapazität
- 70', 75': Ansteuereinrichtung
- 70: Pull-up-Transistor
- 80, 80': Gleichspannungsquelle
- VDD: Betriebsspannung
- IL: Laststrom
- GS: Gate-Sourcespannung
- P: Ein-/Ausschaltsignal

## Patentansprüche

1. Schaltungsanordnung (10) zum Überstrom-freien Ein- und Ausschalten eines Stroms (IL) mit
einer Stromquelle (20),
einer der Stromquelle (20) zugeordneten Last (40), einem Schalttransistor (50) zum Ein- und Ausschalten der Stromquelle (20), wobei der Schalttransistor (50) eine parasitäre Kapazität (60) zwischen der Steuerelektrode (51) und einer ersten, nicht auf konstantem Potential liegenden Ausgangselektrode (52) aufweist, und
einer Kurzschlusseinrichtung (30) zwischen der Steuerelektrode (51) und der ersten Ausgangselektrode (52) der Schalteinrichtung (50) zum Ausschalten der Stromquelle (20).

2. Schaltungsanordnung nach Anspruch 1,
**dadurch gekennzeichnet, dass**
die Kurzschlusseinrichtung (30) einen Transistor umfasst, an dessen Steuerelektrode (31) ein Ein-/Ausschaltesignal (P) anlegbar ist und dessen eine Ausgangselektrode (32) mit der ersten Ausgangselektrode (52) und dessen andere Ausgangselektrode (33) mit der Steuerelektrode (51) des Schalttransistors.(50) verbunden sind.

3. Schaltungsanordnung nach Anspruch 1 oder 2,
**dadurch gekennzeichnet, dass**
der Kurzschlusseinrichtung (30) eine Pull-up-Einrichtung (70) zugeordnet ist.

4. Schaltungsanordnung nach einem der Ansprüche 1 bis 3,
**dadurch gekennzeichnet, dass**
die Stromquelle (20), der Schalttransistor (50), die Kurzschlusseinrichtung (30) und/ oder die Pull-up-Einrichtung (70) als bipolare Transistoren und/oder Feldeffekttransistoren ausgebildet sind.

5. Schaltungsanordnung nach einem der Ansprüche 1 bis 4,
**dadurch gekennzeichnet, dass**
die Last (40) eine Laserdiode ist.

6. Schaltungsanordnung nach Anspruch 4,
**dadurch gekennzeichnet, dass**
der Strom (IL) durch den Schalttransistor (50) ausgeschaltet wird, wenn die an der Steuerelektrode der Stromquelle (20) anliegende konstante Spannung (80) kleiner als die Summe der Schwellenspannungen der Stromquelle (20) und des Schalttransistors (50) ist.

## Claims

1. A circuit arrangement (10) for switching a current (IL) on and off without the occurrence of overcurrent, with
a current source (20),
a load (40) associated with the current source (20),
a switching transistor (50) for switching the current source (20) on and off, the switching transistor (50) having a stray capacity (60) between the control electrode (51) and a first output electrode (52) which is not at a constant potential, and
a short-circuit device (30) between the control electrode (51) and the first output electrode (52) of the switching device (50) for switching the current source (20) off.

2. A circuit arrangement according to claim 1, **characterised in that** the short-circuit device (30) comprises a transistor, to the control electrode (31) of which a switching on/off signal (P) can be applied and one output electrode (32) of which is connected to the first output electrode (52) and the other output electrode (33) of which is connected to the control electrode (51) of the switching transistor (50).

3. A circuit arrangement according to claim 1 or 2, **characterised in that** the short-circuit device (30) has an associated pull-up device (70).

4. A circuit arrangement according to any one of claims 1 to 3, **characterised in that** the current source (20), the switching transistor (50), the short-circuit device (30) and/or the pull-up device (70) are constructed as bipolar transistors and/or field-effect transistors.

5. A circuit arrangement according to any one of claims 1 to 4, **characterised in that** the load (40) is a laser diode.

6. A circuit arrangement according to claim 4, **characterised in that** the current (IL) is switched off by the switching transistor (50) when the constant voltage (80) applied to the control electrode of the current source (20) is smaller than the sum of the threshold voltages of the current source (20) and of the switching transistor (50).

## Revendications

1. Circuit (10) servant à établir ou à couper sans surintensité un courant (IL), lequel comporte :
une source de courant (20) ;
une charge (40) associée à la source de courant (20) ;
un transistor de commutation (50) servant à connecter et à couper la source de courant (20), le transistor de commutation (50) comportant une capacité parasitaire (60) entre l'électrode de commande (51) et une première électrode de sortie (52) qui n'est pas à un potentiel constant ; et
un dispositif de court-circuitage (30) qui est situé entre l'électrode de commande (51) et la première électrode de sortie (52) du dispositif de commutation (50) et qui sert à couper la source de courant (20).

2. Circuit selon la revendication 1,
**caractérisé en ce que** le dispositif de court-circuitage (30) comprend un transistor, transistor à l'électrode de commande (31) duquel un signal de connexion ou de coupure (P) peut être appliqué et dont l'électrode de sortie (32) est reliée à la première électrode de sortie (52) du transistor de commutation (50) et l'autre électrode de sortie (33) à l'électrode de commande (51) dudit transistor de commutation.

3. Circuit selon la revendication 1 ou 2,
**caractérisé en ce qu'**un dispositif d'excursion haute (70) est associé au dispositif de court-circuitage (30).

4. Circuit selon l'une des revendications 1 à 3,
**caractérisé en ce que** la source de courant (20), le transistor de commutation (50), le dispositif de court-circuitage (30) et/ou le dispositif d'excursion haute (70) sont réalisés sous forme de transistors bipolaires et/ou de transistors à effet de champ.

5. Circuit selon l'une des revendications 1 à 4,
**caractérisé en ce que** la charge (40) est une diode laser.

6. Circuit selon la revendication 4,
**caractérisé en ce que** le courant (IL) est coupé par le transistor de commutation (50) si la tension constante (80) appliquée à l'électrode de commande de la source de courant (20) est inférieure à la somme des tensions de seuil de la source de courant (20) et du transistor de commutation (50).
